# EUROPÄISCHE PATENTSCHRIFT

(11) **EP 3 201 984 B1**
(45) Veröffentlichungstag und Bekanntmachung des Hinweises auf die Patenterteilung: **06.03.2019**
(21) Anmeldenummer: 15771095.5
(22) Anmeldetag: 28.09.2015
(51) Int. Cl.: H01M 10/48

(54) **BATTERIE UND VERFAHREN ZU DEREN BETRIEB**
BATTERY AND METHOD FOR OPERATING SAME
BATTERIE ET PROCÉDÉ PERMETTANT DE FAIRE FONCTIONNER LADITE BATTERIE

(30) Priorität: 29.09.2014 DE 102014219720
(43) Veröffentlichungstag der Anmeldung: 09.08.2017
(73) Patentinhaber: Fraunhofer Gesellschaft zur Förderung der angewandten Forschung E.V., 80686 München (DE); Stöbich Technology GmbH, 38644 Goslar (DE)
(72) Erfinder: SCHADE, Wolfgang, 38644 Goslar (DE); STÖBICH, Jochen, Goslar 38640 (DE)
(74) Vertreter: Friese Goeden Patentanwälte PartGmbB
(86) Internationale Anmeldenummer: PCT/EP2015/072229
(87) Internationale Veröffentlichungsnummer: WO 2016/050679

(56) Entgegenhaltungen:
- WO-A2-2014/026867
- KR-B1- 100 812 742
- US-A1- 2014 203 783
- LARS WILKO SOMMER ET AL: "Embedded Fiber Optic Sensing for Accurate State Estimation in Advanced Battery Management Systems", MRS PROCEEDINGS, Bd. 1681, 25. April 2014 (2014-04-25), XP055228880, DOI: 10.1557/opl.2014.560
- LO Y L ED - DRIGGERS RONALD G: "USING IN-FIBER BRAGG-GRATING SENSORS FOR MEASURING AXIAL STRAIN ANDTEMPERATURE SIMULTANEOUSLY ON SURFACES OF STRUCTURES", OPTICAL ENGINEERING, SOC. OF PHOTO-OPTICAL INSTRUMENTATION ENGINEERS, BELLINGHAM, Bd. 37, Nr. 8, 1. August 1998 (1998-08-01) , Seiten 2272-2276, XP000789084, ISSN: 0091-3286, DOI: 10.1117/1.601747

## Beschreibung

Die Anmeldung betrifft eine Batterie mit einem Batteriegehäuse und zumindest einer Batteriezelle und zumindest einem Sensor. Weiterhin betrifft die Erfindung ein Verfahren zur Steuerung oder Regelung der Ladung und/oder Entladung einer Batterie mit zumindest einer Batteriezelle, bei welcher Messwerte mit zumindest einem Sensor erfasst werden. Vorrichtungen und Verfahren dieser Art können dazu verwendet werden, den Lade- oder Entladevorgang einer Batterie zu optimieren und/oder die Batterie vor Zerstörung zu schützen.

Aus der WO 2012/098159 A2 ist eine solche Vorrichtung und ein Verfahren bekannt. Bei dieser bekannten Batterie wird die Temperatur einer jeden Batteriezelle durch einen faseroptischen Sensor erfasst. Dies erlaubt eine große Anzahl von Messstellen und eine von EMV-Einflüssen unbeeinflusste Messung. Aus der Temperatur der Batteriezellen kann auf deren Belastung mit einem Lade- bzw. Entladestrom geschlossen werden, sodass die allmähliche Verschlechterung einzelner Zellen der Batterie erkennbar ist. Die WO2014/026867 A2 zeigt ein planaroptisches Element mit zumindest einer photonischen Komponente, welche in zumindest einem Träger angeordnet ist, welcher zumindest ein Polymer enthält oder daraus besteht, wobei der Träger zumindest eine erste Folienlage mit einer ersten Seite und einer gegenüberliegenden zweiten Seite und eine zweite Folienlage mit einer ersten Seite und einer gegenüberliegenden zweiten Seite aufweist, wobei die erste Seite der zweiten Folienlage auf der zweiten Seite der ersten Folienlage angeordnet ist und zumindest die zweite Folienlage in zumindest einer Teilfläche Nanodrähte enthält. Weiterhin betrifft die Erfindung ein entsprechendes Sensorelement und ein Verfahren zu dessen Herstellung.

US2014/0203783 A1 behandelt Systeme und Verfahren zum Überwachen und /oder Steuern von Energiespeichervorrichtungen, Energiesystemen und anderen derartigen elektrochemischen Energievorrichtungen, die Elektrodenmaterialien und Gastspezies verwenden, um elektrische Energie für eine angeschlossene Last zu erzeugen.

Die KR 10-0812742 B offenbart eine Sekundärbatterie umfassend eine Mehrzahl von Batteriezellen, die elektrisch miteinander verbunden sind, und eine Zelltemperaturerfassungseinheit, die mit einer optischen Faser versehen ist, die eine Vielzahl von Faser-Bragg-Gitter (FBG) -Sensoren aufweist, um die Temperatur jeder Zelle zu erfassen.

Diese bekannte Vorrichtung erlaubt jedoch nicht, den Ladezustand zu messen, d.h. die in den einzelnen Batteriezellen gespeicherte Ladung zu bestimmen.

Ausgehend vom Stand der Technik liegt der Erfindung somit die Aufgabe zugrunde, eine Batterie und ein Verfahren zu deren Steuerung oder Regelung anzugeben, mit welchem die in der jeweiligen Batteriezelle gespeicherte Ladung bestimmbar ist. Weiterhin liegt der Erfindung die Aufgabe zugrunde, eine Batterie anzugeben, bei welcher der Ausfall einzelner Batteriezellen frühzeitig erkannt wird. Hierdurch kann der Brandschutz einer solchen Batterie verbessert sein.

Die Aufgabe wird erfindungsgemäß durch eine Batterie gemäß Anspruch 1 und ein Verfahren zur Steuerung oder Regelung gemäß Anspruch 14 gelöst. Vorteilhafte Weiterbildungen der Erfindung sind in den Unteransprüchen beschrieben.

Erfindungsgemäß wird vorgeschlagen, eine Batterie mit einem Batteriegehäuse zu versehen, welches zumindest eine Batteriezelle enthält. Das Batteriegehäuse kann in einigen Ausführungsformen der Erfindung aus Metall, einer Legierung oder Kunststoff bestehen und eine optionale Faserverstärkung aufweisen. Das Batteriegehäuse kann beispielsweise in einem Spritzgussverfahren hergestellt sein. Das Batteriegehäuse kann eine flammhemmende Ausrüstung und oder Trennwände aufweisen, sodass das Batteriegehäuse dazu geeignet ist, die Ausbreitung eines Brandes einer Batteriezelle auf die gesamte Batterie und/oder ein die Batterie enthaltendes Fahrzeug oder Gebäude zu verhindern.

Die zumindest eine Batteriezelle ist dazu vorgesehen, chemische Energie in elektrische Energie zu wandeln. Beispielsweise kann die Batteriezelle zumindest eine Sekundärzelle umfassen. In einigen Ausführungsformen der Erfindung kann die Batteriezelle eine Lithium-Polymerzelle, eine Nickel-Cadmiumzelle, eine Nickel-Metallhydridzelle oder eine Natrium-Nickelchloridzelle sein oder eine solche enthalten. Sofern die Batterie eine Mehrzahl von Batteriezellen enthält, können diese seriell und/oder parallel verschaltet sein, um auf diese Weise die von der Batterie bereitgestellte elektrische Spannung und/oder den der Batterie entnehmbaren elektrischen Strom zu vergrößern.

Die Batterie ist mit zumindest einem Sensor versehen, welcher die Größe bzw. die Größenänderung der Batteriezelle oder des Batteriegehäuses erfasst. Erfindungsgemäß wurde nämlich erkannt, dass die Batteriezelle beim Fließen eines Lade- oder Entladestroms nicht nur erwärmt wird, sondern auch eine mechanische Ausdehnung der Batteriezelle in Abhängigkeit des Ladezustands auftritt. Diese mechanische Ausdehnung kann durch den vorgeschlagenen Sensor erfasst werden, sodass durch die Messung der mechanischen Ausdehnung Rückschlüsse auf den Ladezustand und/oder den Ladestrom und/oder den Entladestrom möglich sind. Auch eine Beschädigung oder ein Drohender Ausfall einer Batteriezelle kann aufgrund übermäßig großer Ausdehnung frühzeitig erkannt werden.

In einigen Ausführungsformen der Erfindung kann der Sensor eine mechanische Spannung erfassen, welche bei der Größenänderung der Batteriezelle oder des Batteriegehäuses induziert wird. In einigen Ausführungsformen der Erfindung kann der Sensor einen Dehnungsmessstreifen enthalten oder daraus bestehen.

In einigen Ausführungsformen der Erfindung kann der Sensor dazu eingerichtet sein, zusätzlich eine Temperatur zu erfassen. Durch die Erfassung von Temperatur und mechanischer Ausdehnung können Rückschlüsse auf den Ladezustand und/oder den Ladestrom und/oder den Entladestrom mit größerer Genauigkeit erfolgen.

Die Daten des Sensors können zur Steuerung des Lade- und/oder Entladestroms der Batterie bzw. einzelner Batteriezellen verwendet werden oder um bei drohender Tiefentladung oder drohender Überladung einzelne Batteriezellen eine Abschaltung vorzunehmen, ehe die Batterie in Brand gerät.

Gemäss der Erfindung ist der Sensor ein faseroptischer Sensor, welcher zumindest einen Wellenleiter mit zumindest einem Kern und einem den Kern umgebenden Mantel aufweist. In einigen Ausführungsformen der Erfindung kann der Wellenleiter aus Glas oder Kunststoff bestehen, wobei der Kern einen ersten Brechungsindex und der Mantel einen zweiten Brechungsindex aufweist. Die Brechungsindizes von Kern und Mantel sind so gewählt, dass an der Grenzfläche zwischen Kern und Mantel Totalreflexion auftritt. Hierdurch kann ein optisches Signal im Kern geführt werden.

Der Kern weist in einzelnen, vorgebbaren Längsabschnitten des Wellenleiters periodische Bereiche auf, welche im Vergleich zum umgebenden Material des Kernes einen geänderten Brechungsindex aufweisen. Die periodischen Bereiche können durch Bestrahlung mit einem Laser erhalten werden, beispielsweise kann ein Kurzpulslaser verwendet werden. Eine Mehrzahl solcher Bereiche bildet ein Faser-Bragg-Gitter, welches eine vorgebbare Wellenlänge oder einen vorgebbaren Wellenlängenbereich des elektromagnetischen Spektrums reflektiert und andere Strahlung transmittiert. Die reflektierte Wellenlänge bzw. der reflektierte Wellenlängenbereich kann als Bragg-Wellenlänge bezeichnet werden. Die Bragg-Wellenlänge hängt vom Anstand der periodischen Bereiche, d.h. von der Gitterkonstanten des Faser-Bragg-Gitters ab.

Erfindungsgemäss enthält der Wellenleiter zumindest ein erstes Faser-Bragg-Gitter und zumindest ein zweites Faser-Bragg-Gitter. Hierbei ist das erste Faser-Bragg-Gitter mechanisch mit dem Batteriegehäuse und/oder der Batteriezelle gekoppelt und das zweite Faser-Bragg-Gitter ist mechanisch vom Batteriegehäuse oder der Batteriezelle entkoppelt. Die Gitterkonstante des Faser-Bragg-Gitters und damit die Bragg-Wellenlänge ändert sich bei Ausdehnung oder Schrumpfung des Wellenleiters. Solche Ausdehnungen können einerseits thermisch bei Temperaturänderung auftreten als auch mechanisch, wenn der Wellenleiter des faseroptischen Sensors einer mechanischen Spannung ausgesetzt wird. Erfindungsgemäß wird nun vorgeschlagen, durch Bestimmung der Bragg-Wellenlänge des zweiten Faser-Bragg-Gitters die Temperatur des Batteriegehäuses bzw. der Batteriezelle zu bestimmen und durch Bestimmung der Bragg-Wellenlänge des ersten Faser-Bragg-Gitters eine mechanische Spannung des Batteriegehäuses oder der Batteriezelle zu bestimmen, welche durch Ausdehnung des Batteriegehäuses oder der Batteriezelle auf den Wellenleiter des faseroptischen Sensors einwirkt. Erfindungsgemäß wurde nämlich erkannt, dass die Batteriezelle beim Fließen eines Lade- oder Entladestroms nicht nur erwärmt wird, sondern auch eine mechanische Ausdehnung der Batteriezelle in Abhängigkeit des Ladezustands auftritt. Diese mechanische Ausdehnung kann durch den faseroptischen Sensor mit großer Genauigkeit und Zuverlässigkeit erfasst werden, sodass durch die Erfassung von Temperatur und mechanischer Ausdehnung Rückschlüsse auf den Ladezustand und/oder den Ladestrom und/oder den Entladestrom möglich sind. Die faseroptische Messung weist gegenüber einer elektrischen Erfassung der Messgrößen durch Widerstandssensoren eine höhere Genauigkeit und/oder eine bessere EMV-Verträglichkeit auf.

In einigen Ausführungsformen kann das zweite Faser-Bragg-Gitter in einem Hohlraum angeordnet sein. Dies erlaubt eine relative Verschiebung zwischen dem Längsabschnitt des Wellenleiters, welcher das zweite Faser-Bragg-Gitter enthält und dem Batteriegehäuse bzw. der Batteriezelle, sodass in das zweite Faser-Bragg-Gitter keine mechanischen Spannungen eingeleitet werden. Hierdurch wird eine zuverlässige Temperaturmessung ermöglicht.

In einigen Ausführungsformen kann zumindest der Längsabschnitt des Wellenleiters, welcher das zweite Faser-Bragg-Gitter enthält, in einem Rohr verlaufen. Das Rohr kann in die Wandung des Batteriegehäuses bzw. eine Batteriezelle eingebettet sein oder mit dem Batteriegehäuse bzw. der Batteriezelle verbunden sein. Eine solche Verbindung kann in einigen Ausführungsformen der Erfindung durch Kleben, Schweißen oder Umspritzen oder Laminieren erfolgen. Bei der Endmontage des faseroptischen Sensors kann der Wellenleiter durch das Rohr gezogen werden, sodass zumindest das zweite Faser-Bragg-Gitter innerhalb des Rohres zu liegen kommt, sodass eine relative Verschiebung zwischen Wellenleiter und Batteriegehäuse ermöglicht wird, sodass das zweite Faser-Bragg-Gitter von mechanischen Spannungen unbeeinflusst bleibt.

In einigen Ausführungsformen kann zumindest der Längsabschnitt des Wellenleiters, welcher das zweite Faser-Bragg-Gitter enthält, mit einer Faserverstärkung versehen sein. Eine Faserverstärkung kann in einigen Ausführungsformen der Erfindung Glasfasern und/oder Kohlefasern und/oder Aramidfasern enthalten oder daraus bestehen. Die Faserverstärkung vermeidet eine übermäßige Ausdehnung des Wellenleiters beim Einwirken mechanischer Spannungen, sodass das zweite Faser-Bragg-Gitter im Wesentlichen auf Temperaturänderungen reagiert. Somit wird auch in dieser Ausführungsform die getrennte Bestimmung von mechanischer Spannung und damit Ausdehnung des Batteriegehäuses bzw. der Batteriezelle und Temperatur möglich.

In einigen Ausführungsformen kann der faseroptische Sensor zumindest abschnittsweise mit dem Batteriegehäuse und/oder zumindest einer Batteriezelle verklebt, verschweißt, umspritzt oder laminiert sein. Die Verklebung des faseroptischen Sensors bewirkt eine weitgehend starre Verbindung zwischen dem Wellenleiter und der Batteriezelle bzw. dem Batteriegehäuse, sodass bei Ausdehnung der Batteriezelle der faseroptische Sensor eine Längenänderung erfährt, welche zu einer Änderung der Bragg-Wellenlänge des ersten Faser-Bragg-Gitters führt. Darüber hinaus wird der faseroptische Sensor durch die Verklebung zu einem integralen Bestandteil der Batteriezelle bzw. der Batterie, so dass eine mechanische Beschädigung vermieden werden kann.

Erfindungsgemäss ist der faseroptische Sensor in eine Trägerfolie eingebettet. Bei der Endmontage der Batterie kann die Trägerfolie mit dem faseroptischen Sensor auf zumindest eine Batteriezelle oder das Batteriegehäuse aufgeklebt werden. Sofern die Trägerfolie bei Wärmeeinwirkung kleiner wird, kann die Trägerfolie mit dem faseroptischen Sensor in an sich bekannter Weise auf eine Batteriezelle aufgeschrumpft werden. Dies erlaubt eine einfache Befestigung des faseroptischen Sensors auf an sich bekannte Batteriezellen, sodass die erfindungsgemäße faseroptische Sensorik auch mit an sich bekannten Komponenten realisiert werden kann und besonders einfach auf einer Fertigungslinie Batterien mit und ohne Sensorik herstellbar sind.

Dabei weist die Trägerfolie Flächenbereiche auf, in welcher eine Faserverstärkung eingebracht ist. Die Flächenbereiche mit Faserverstärkung sind so gewählt, dass diese mechanische Spannungen zumindest teilweise aufnehmen können und hierdurch deren Einfluss auf die Bragg-Wellenlänge des zweiten Faser-Bragg-Gitters nicht oder nur in geringerem Ausmaß beeinflussen.

In einigen Ausführungsformen kann die Trägerfolie eine Aussparung aufweisen, wobei zumindest der Längsabschnitt des faseroptischen Sensors, welcher das zweite Faser-Bragg-Gitter enthält, in der Aussparung angeordnet ist. Beim Aufkleben der Trägerfolie auf eine Batteriezelle wird somit das erste Faser-Bragg-Gitter kraftschlüssig mit dem Gehäuse der Batteriezelle verbunden, sodass deren Ausdehnung bestimmt werden kann. Das zweite Faser-Bragg-Gitter ist jedoch in der Ausnehmung von der Batteriezelle entkoppelt, sodass eine Temperaturmessung mit hoher Genauigkeit vorgenommen werden kann.

In einigen Ausführungsformen der Erfindung kann jeder Batteriezelle einer Batterie zumindest ein erstes Faser-Bragg-Gitter und zumindest ein zweites Faser-Bragg-Gitter zugeordnet sein. Dies erlaubt die Messung der Ausdehnung und der Temperatur einer jeden einzelnen Zelle, sodass deren Ladeströme, Entladeströme und Ladezustand einzeln überwacht werden kann. Hierdurch können einzelne Batteriezellen einer größerer Batterie optimiert geladen oder entladen werden oder bei Fehlfunktion abgeschaltet werden. Die Leistung und/oder die Lebensdauer einer solchen Batterie können hierdurch verbessert sein. Durch Erfassung der Temperatur ist auch eine Branderkennung möglich, so dass die Batterie im Brandfall abgeschaltet werden kann und/oder eine Löscheinrichtung oder eine Alarmeinrichtung ausgelöst werden kann.

In einigen Ausführungsformen der Erfindung enthält die Batterie weiterhin eine Steuer- und/oder Regeleinrichtung, welche mit zumindest einem faseroptischen Sensor gekoppelt ist. Dies erlaubt eine besonders einfache Handhabung der Batterie, welche in an sich bekannter Weise lediglich zwei Anschlusskontakte bereitstellt, über welche ein Ladestrom zugeführt oder ein Entladestrom entnommen werden kann. Die Verteilung dieser Ströme auf die einzelnen Batteriezellen wird von der Steuer- oder Regeleinrichtung im Inneren der Batterie ohne Zutun des Benutzers automatisiert und anhand der Messergebnisse des mindestens einen faseroptischen Sensors kontrolliert.

Nachfolgend soll die Erfindung anhand von Figuren ohne Beschränkung des allgemeinen Erfindungsgedankens näher erläutert werden. Dabei zeigt
Figur 1 ein Blockschaltbild einer erfindungsgemäßen Batterie.
Figur 2 zeigt eine mögliche Befestigung eines faseroptischen Sensors an einer Batteriezelle.
Figur 3 zeigt eine Trägerfolie mit einem faseroptischen Sensor in einer ersten Ausführungsform.
Figur 4 zeigt eine Trägerfolie mit einem faseroptischen Sensor gemäß einer zweiten Ausführungsform der Erfindung.
Figur 5 zeigt gemessene Werte der Dehnung einer Batteriezelle in Abhängigkeit des elektrischen Stromes.
Figur 6 zeigt die Abhängigkeit der Dehnung einer Batteriezelle von der elektrischen Spannung.
Figur 7 zeigt den Verlauf der Dehnung und der Temperatur einer Batteriezelle bei der Überladung.

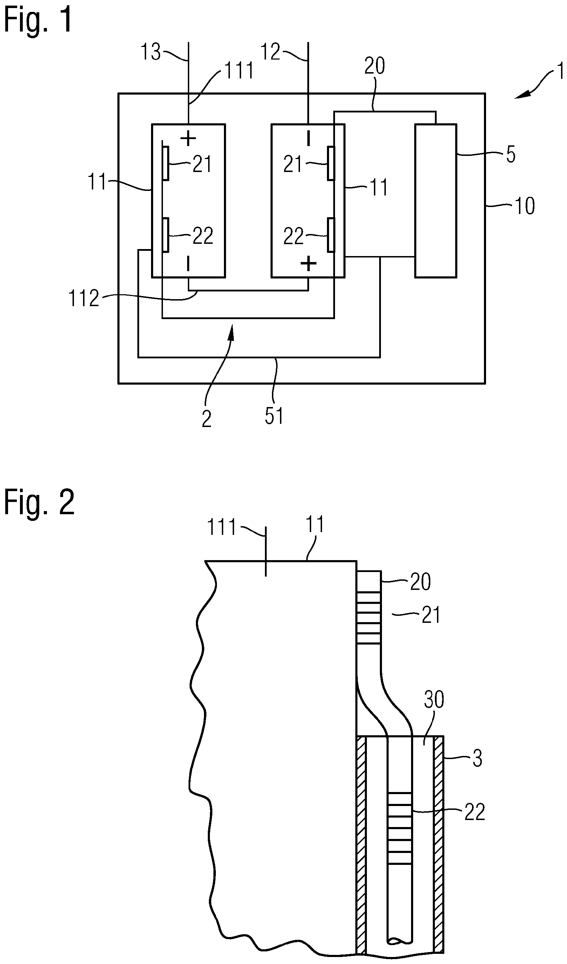

Figur 1 zeigt ein Blockschaltbild einer erfindungsgemäßen Batterie 1. Die Batterie 1 enthält zumindest eine Batteriezelle 11. In einigen Ausführungsformen der Erfindung kann eine Mehrzahl von Batteriezellen 11 vorhanden sein, welche parallel oder seriell miteinander verschaltet sind, um die Ausgangsspannung und/oder den Ausgangsstrom der Batteriezelle 1 zu erhöhen. In Figur 1 sind beispielhaft zwei Batteriezellen 11 dargestellt, welche seriell miteinander verschaltet sind, sodass an den Anschlusskontakten 12 und 13 der Batterie 1 eine elektrische Spannung und ein elektrischer Strom abgegriffen werden kann.

Die Batteriezellen 11 weisen einen ersten Anschlusskontakt oder Plus-Pol 111 sowie einen zweiten Anschlusskontakt bzw. Minus-Pol 112 auf. Die Batteriezelle 11 kann beispielsweise ein an sich bekannter Lithiumionenakkumulator sein. Die Batteriezelle 11 kann eine an sich bekannte Bauform aufweisen. In einigen Ausführungsformen der Erfindung kann die Batteriezelle 11 eine Rundzelle sein, welche eine in etwa zylindrische Grundform aufweist.

Der Ladezustand, der Ladestrom und der Entladestrom der Batteriezellen 11 werden im dargestellten Ausführungsbeispiel über einen faseroptischen Sensor 20 überwacht. Der faseroptische Sensor 20 weist zwei erste Faser-Bragg-Gitter 21 sowie zwei zweite Faser-Bragg-Gitter 22 auf. Die Faser-Bragg-Gitter sind entlang der Längserstreckung des Wellenleiters 20, welcher Teil des faseroptischen Sensors 2 ist, so verteilt, dass jeder Batteriezelle 11 zumindest ein erstes Faser-Bragg-Gitter 21 und ein zweites Faser-Bragg-Gitter 22 zugeordnet ist.

Das erste Faser-Bragg-Gitter ist kraftschlüssig mit der Batteriezelle 11 verbunden, sodass bei mechanischer Ausdehnung der Batteriezelle 11 eine mechanische Spannung im Wellenleiter 20 induziert wird, welche zu einer Veränderung der Bragg-Wellenlänge des ersten Faser-Bragg-Gitters 21 führt. Somit kann aus der Veränderung der Bragg-Wellenlänge auf die Ausdehnung bzw. Umfangsänderung der Batteriezelle 11 geschlossen werden.

Das zweite Faser-Bragg-Gitter 22 ist mechanisch von der Batteriezelle 11 entkoppelt. Jedoch weist der Längsabschnitt, welcher das zweite Faser-Bragg-Gitter 22 enthält, eine thermische Kopplung zur Batteriezelle 11 auf. Somit kann die Temperatur der Batteriezelle durch die Änderung der Bragg-Wellenlänge des zweiten Faser-Bragg-Gitters 22 ermittelt werden.

Die vier in Figur 1 dargestellten Faser-Bragg-Gitter können aufgrund ihrer Bragg-Wellenlänge unterschieden werden. Somit ist eine eindeutige Zuordnung des Messortes und damit die getrennte Erfassung von Dehnung und Temperatur für beide Batteriezellen 11 möglich.

Das in Figur 1 anhand von zwei Batteriezellen gezeigte Konzept ist leicht auf größere Batterien mit mehreren Batteriezellen 11 skalierbar.

Die Verwendung faseroptischer Sensoren weist den Vorteil besserer EMV-Verträglichkeit auf. Weiterhin können mit nur wenigen Wellenleitern 20 und damit mit geringem Verkabelungsaufwand viele Messstellen realisiert werden, um auch große Batterien mit vielen Batteriezellen zu überwachen. Alternativ können aber auch an sich bekannte Dehnungsmessstreifen und/oder Widerstandsthermometer verwendet werden, um die Größenänderung und die Temperatur zu erfassen.

In gleicher Weise wie für die Batteriezellen 11 gezeigt, kann der faseroptische Sensor 2 alternativ oder zusätzlich die Ausdehnung und die Temperatur eines Batteriegehäuses 10 der Batterie 1 überwachen.

Im Ausführungsbeispiel gemäß Figur 1 enthält die Batterie 1 weiterhin eine Steuer- und/oder Regeleinheit 5. Zur Vereinfachung wird im nachfolgenden Text lediglich auf eine Steuerungseinrichtung 5 Bezug genommen. Dies soll stets auch die Alternativen einer Regeleinrichtung bzw. einer kombinierten Steuer- und Regeleinrichtung einschließen.

Die Steuereinrichtung 5 kann beispielsweise einen Mikroprozessor oder einen Microcontroller enthalten oder daraus bestehen. Alternativ kann die Steuereinrichtung 5 als FPGA oder diskrete elektronische Schaltung realisiert sein. Die Steuereinrichtung 5 enthält im dargestellten Ausführungsbeispiel eine Lichtquelle und ein mikrooptisches Spektrometer, um den faseroptischen Sensor 2 direkt auszulesen. In anderen Ausführungsformen der Erfindung können diese Bauteile in einer separaten Schaltung vorhanden sein, sodass der Steuereinrichtung 5 die Messwerte des faseroptischen Sensors 2 als optisches oder elektrisches Datensignal zur Verfügung gestellt werden.

Die Steuereinrichtung 5 ist weiterhin mit einer Steuerleitung 51 versehen, welche einzelne Batteriezellen 11 beeinflussen kann, beispielsweise über ein Trennrelais. Die Steuereinrichtung 5 überwacht somit im Betrieb die Ausdehnung und Temperatur der Batteriezellen 11. Aus der Ausdehnung und der Temperatur kann auf einen Ladestrom und/oder Entladestrom und/oder Ladezustand geschlossen werden, beispielsweise durch Berechnung dieser Werte aus den Eingangsgrößen in einem Modell der Batteriezellen 11 oder über eine Umsetzungstabelle.

Bei Übersteigen der Werte für Ladestrom oder -spannung, unzulässiger Temperaturerhöhung, Überladung, Tiefentladung oder unzulässig große Ausdehnung können einzelne Batteriezellen über die Steuerleitung 51 vom Stromkreis getrennt werden, um deren Beschädigung zu verhindern. Insbesondere kann verhindert werden, dass einzelne Batteriezellen 11 in Brand geraten und dass Feuer über benachbarte Batteriezellen 11 auf die Umgebung der Batterie 1 übergreift.

Figur 2 zeigt beispielhaft eine einzelne Batteriezelle 11 mit einem ersten Anschlusskontakt 111. An der Oberfläche der Batteriezelle 11 ist zumindest ein Wellenleiter 20 mit zumindest einem ersten Längsabschnitt festhaftend angebracht. Die Verbindung des Wellenleiters 20 mit der Batteriezelle 11 kann durch Verklebung, Verschweißung oder Klemmung erfolgen. Dieser Längsabschnitt enthält das erste Faser-Bragg-Gitter 21, sodass sich dessen Gitterkonstante und damit die Bragg-Wellenlänge bei Ausdehnung der Batteriezelle 11 vergrößert und bei Verkleinerung der Batteriezelle 11 verringert. Hierdurch erlaubt die Bestimmung der Bragg-Wellenlänge des ersten Faser-Bragg-Gitters 21 die Bestimmung der Ausdehnung der Batteriezelle 11.

Zur Bestimmung der Temperatur der Batteriezelle 11 steht ein zweites Faser-Bragg-Gitter 22 zur Verfügung, welches an einem Längsabschnitt des Wellenleiters 20 angeordnet ist, welcher mechanisch von der Batteriezelle 11 entkoppelt ist.

Die mechanische Entkopplung kann durch ein Rohr 3 erfolgen, welches durch Verklebung oder Verschweißung an der Batteriezelle 11 befestigt ist und durch dessen Innenraum 30 der Wellenleiter 20 geführt ist. Der Wellenleiter 20 ist somit im Innenraum 30 des Rohres 3 frei beweglich. Insbesondere kann sich die Batteriezelle 11 ausdehnen, ohne dass das zweite Faser-Bragg-Gitter 22 hierdurch beeinflusst wird. Gleichzeitig verbleibt jedoch eine thermische Kopplung des Faser-Bragg-Gitters 22 mit der Batteriezelle 11, sodass deren Temperatur bestimmt werden kann.

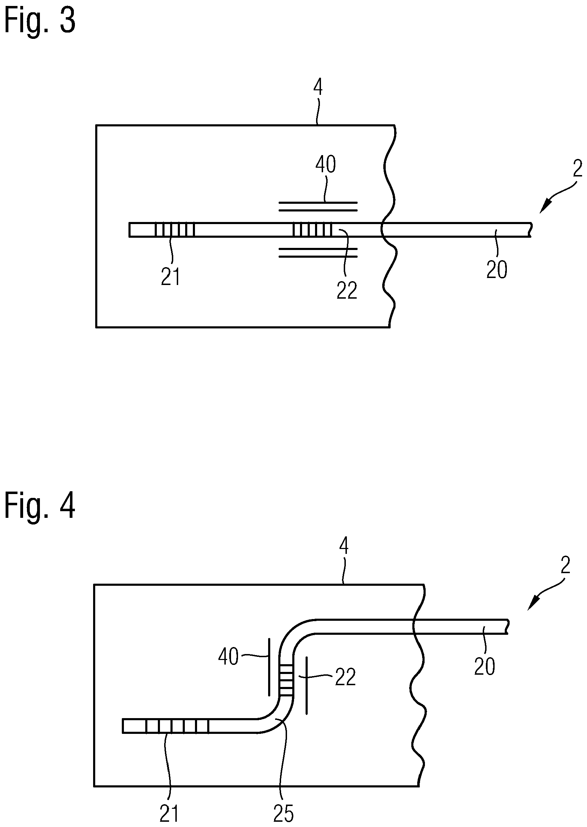

Figur 3 und Figur 4 zeigen alternative Ausführungsformen der Erfindung. Die Figuren 3 und 4 zeigen jeweils Trägerfolien 4, welche einen eingebetteten faseroptischen Sensor 2 aufweisen. Die Trägerfolien können durch Verkleben, Verschweißen oder Aufschrumpfen mit einer Batteriezelle 11 oder einem Batteriegehäuse 10 verbunden werden, um die Temperatur und die Ausdehnung dieser Bauteile zu messen. Die Trägerfolie 4 weist Flächenbereiche auf, welche eine Faserverstärkung 40 aufweisen. Die Faserverstärkung 40 bedeckt zumindest einen Teil der Fläche, in welcher das zweite Faser-Bragg-Gitter 22 angeordnet ist. Hierdurch wird die mechanische Ausdehnung der Trägerfolie 4 im Bereich des zweiten Faser-Bragg-Gitters 22 begrenzt. Im Bereich des ersten Faser-Bragg-Gitters 21 fehlt eine solche Faserverstärkung, sodass bei Ausdehnung der Trägerfolie aufgrund einer Ausdehnung der Batteriezelle eine größere mechanische Spannung und damit eine größere Änderung der Bragg-Wellenlänge auf das erste Faser-Bragg-Gitter 21 ausgeübt wird.

In Figur 4 weist der Wellenleiter 20 zumindest eine Biegung 25 auf, sodass der Längsabschnitt mit dem zweiten Faser-Bragg-Gitter 22 in etwa orthogonal zum Längsabschnitt mit dem ersten Faser-Bragg-Gitter 21 verläuft. Sofern die Trägerfolie 4 so auf eine Rundzelle aufgebracht wird, dass das erste Faser-Bragg-Gitter 21 radial verläuft, ist das zweite Faser-Bragg-Gitter 22 axial orientiert. Hierdurch wird auf das erste Faser-Bragg-Gitter 21 bei Ausdehnung der Batteriezelle 11 eine größere mechanische Spannung ausgeübt, sodass die Ausdehnung mit größerer Zuverlässigkeit und/oder größerer Genauigkeit erfasst werden kann. Da das zweite Faser-Bragg-Gitter 22 in etwa orthogonal zum ersten Faser-Bragg-Gitter 21 verläuft, wird dieses von der Ausdehnung der Batteriezelle 11 in geringerem Umfang beeinflusst, sodass die Genauigkeit der Temperaturmessung erhöht ist. Durch die Faserverstärkung 40 kann diese Genauigkeit nochmals vergrößert werden.

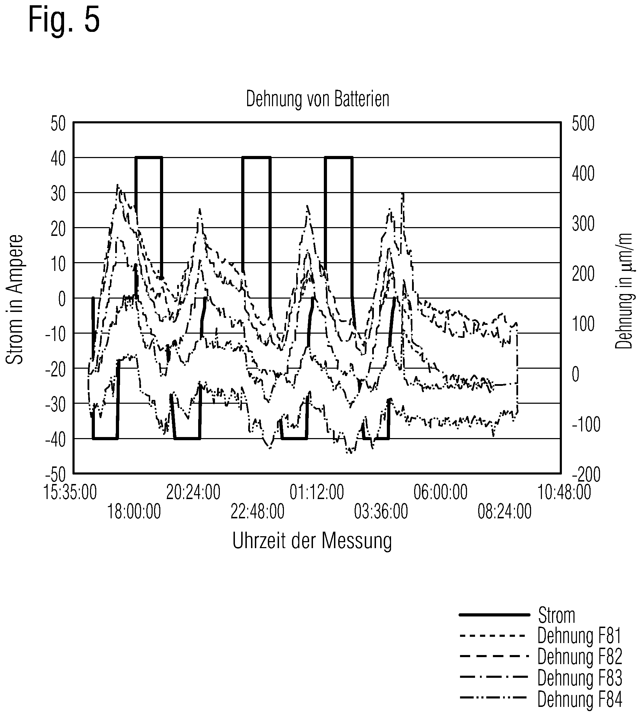

Figur 5 zeigt den einer Batterie entnommenen bzw. zugeführten Strom auf der linken Ordinate und die gemessene Ausdehnung der Batteriezelle 11 auf der rechten Ordinate. Auf der Abszisse ist die Zeit aufgetragen.

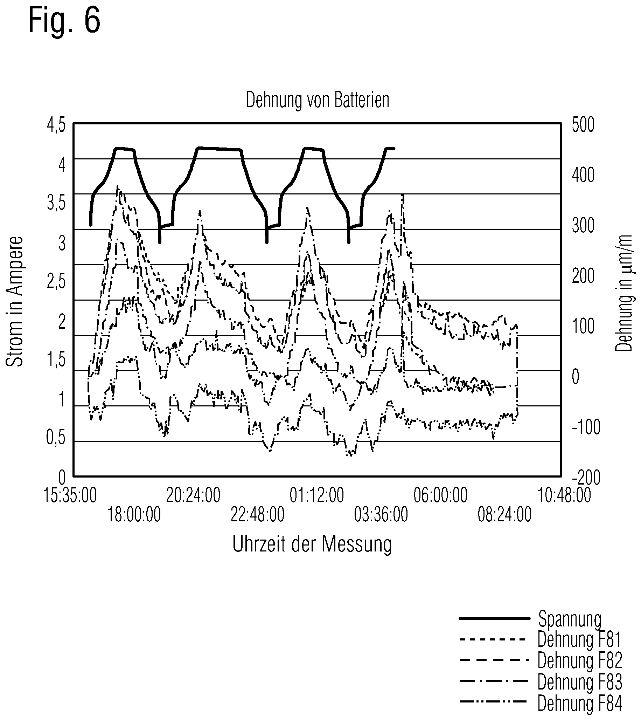

Figur 6 zeigt ebenfalls die Zeit auf der Abszisse und die Dehnung auf der rechten Ordinate. Auf der linken Ordinate ist die Spannung der Batteriezelle in Volt angegeben.

Die Batteriezelle ist mit vier ersten Faser-Bragg-Gittern 21 versehen, welche an unterschiedlichen Stellen der Batteriezelle befestigt sind.

Im zeitlichen Verlauf wird zunächst ein Ladestrom eingeschaltet und der Batteriezelle 11 zugeführt. Nach einer Ladezeit wird der Strom abgeschaltet und die Batteriezelle sich selbst überlassen. Danach wird ein Entladestrom von 40 Ampere für eine bestimmte Zeitdauer entnommen. Dieser Zyklus wird mehrfach wiederholt.

Wie Figur 5 und Figur 6 zeigen, dehnt sich die Batteriezelle mit zunehmender Dauer des Ladevorganges aus. Nach Abschalten des Ladestromes relaxiert die Dehnung, erreicht jedoch nicht ihren Ursprungswert. Somit kann aus der Dehnung auf den Ladezustand geschlossen werden. Während der Entladung nimmt die Dehnung weiter ab, bis diese am Ende des Entladezykluses nahezu ihren Ausgangswert erreicht.

Wie Figur 5 und Figur 6 weiter zeigen, gibt es auf der Oberfläche der Batteriezelle 11 Teilflächen, welche eine geringere Dehnung aufweisen als andere Teilflächen. Diese Teilflächen eignen sich daher besonders zur Messung der Temperatur, da der Messfehler durch große mechanische Spannungen gering gehalten werden kann.

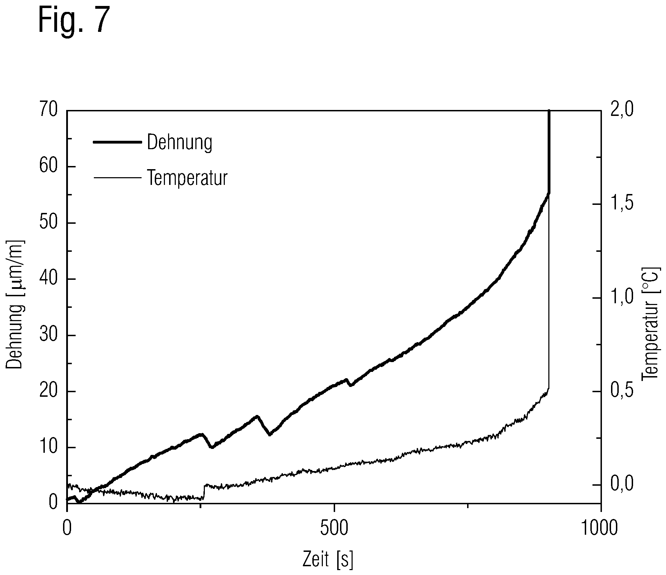

Figur 7 zeigt den Verlauf der Dehnung und der Temperatur einer Batteriezelle bei der Überladung.

Auf der Abszisse ist die Zeit in Sekunden dargestellt. Die linke Ordinate zeigt die Dehnung der Batteriezelle in µm/m und die rechte Ordinate zeigt den Verlauf der Temperatur der Batteriezelle. Im dargestellten Zeitbereich findet eine kontinuierliche Überladung der Batteriezelle statt.

Wie aus Figur 7 ersichtlich ist, erhöht sich die Temperatur zunächst nur um lediglich um 0.5°C. Erst bei sehr großer Überladung kommt es zu einem plötzlichen Temperaturanstieg, der dann zum Brand und damit zu einem Gefahrenfall führen kann. Ein alleiniges Überwachen der Temperatur kann daher nur bedingt zur Vorhersage eines Defektes der Batteriezelle verwendet werden.

Wird jedoch erfindungsgemäß die Dehnung der Zelle erfasst, zeigt sich ein kontinuierlicher Anstieg der Dehnung. Im dargestellten Beispiel kann bereits bei einem Schwellwert von 50 µm/m ein Alarm ausgegeben und/oder die schadhafte Zelle ausgeschaltet werden. Da der vorgeschlagene faseroptische Sensor eine Messgenauigkeit von weniger als 10 µm/m oder von weniger als 5 µm/m oder weniger als 2 µm/m oder weniger als 1 µm/m aufweist, kann die Überladung und der drohende Ausfall der Batteriezelle zuverlässig erfasst werden.

Selbstverständlich ist die Erfindung nicht auf die in den Figuren dargestellte Ausführungsform beschränkt. Die vorstehende Beschreibung ist daher nicht als beschränkend, sondern als erläuternd anzusehen. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Sofern die Ansprüche und die vorstehende Beschreibung "erste" und "zweite" Merkmale definieren, so dient diese Bezeichnung der Unterscheidung zweier gleichartiger Merkmale, ohne eine Rangfolge festzulegen.

## Patentansprüche

1. Batterie (1) mit einem Batteriegehäuse (10) und zumindest einer Batteriezelle (11) und zumindest einem faseroptischen Sensor (2), welcher zumindest einen Wellenleiter (20) mit einem Kern und einem den Kern umgebenden Mantel aufweist, wobei im Kern zumindest ein erstes Faser-Bragg-Gitter (21) eingebracht ist, welches mechanisch mit dem Batteriegehäuse (10) und/oder der Batteriezelle (11) gekoppelt ist, und
im Kern zumindest ein zweites Faser-Bragg-Gitter (22) eingebracht ist, wobei das zweite Faser-Bragg-Gitter (22) mechanisch von dem Batteriegehäuse (10) und der Batteriezelle (11) entkoppelt ist, und
**dadurch gekennzeichnet, dass** der Sensor (2) in eine Trägerfolie (4) eingebettet ist und das zweite Faser-Bragg-Gitter (22) in einer Teilfläche der Trägerfolie (4) angeordnet ist, in welcher eine Faserverstärkung (40) eingebracht ist.

2. Batterie nach Anspruch 1, **dadurch gekennzeichnet, dass** der Wellenleiter (20) zumindest eine Biegung (25) aufweist, sodass der Längsabschnitt mit dem zweiten Faser-Bragg-Gitter (22) in etwa orthogonal zum Längsabschnitt mit dem ersten Faser-Bragg-Gitter (21) verläuft.

3. Batterie nach einem der Ansprüche 1 oder 2, **dadurch gekennzeichnet, dass** die Trägerfolie durch Verkleben, Verschweißen oder Aufschrumpfen mit einer Batteriezelle (11) oder einem Batteriegehäuse (10) verbunden ist.

4. Batterie nach einem der Ansprüche 1 bis 3, **dadurch gekennzeichnet, dass** jeder Batteriezelle (11) einer Batterie (1) zumindest ein erstes Faser-Bragg-Gitter (21) und zumindest ein zweites Faser-Bragg-Gitter (22) zugeordnet ist.

5. Batterie nach einem der Ansprüche 1 bis 4, weiterhin enthaltend eine Steuer- und/oder Regeleinrichtung (5), welche mit zumindest einem Sensor (2) gekoppelt ist.

6. Batterie nach Anspruch 5, **dadurch gekennzeichnet, dass** die Steuer- und/oder Regeleinrichtung (5) eine Lichtquelle und ein mikrooptisches Spektrometer enthält.

7. Batterie nach Anspruch 5 oder 6, **dadurch gekennzeichnet, dass** die Steuer- und/oder Regeleinrichtung (5) einen Mikroprozessor oder einen Mikrocontroller enthält oder daraus besteht.

8. Batterie nach einem der Ansprüche 5 bis 7, **dadurch gekennzeichnet, dass** die Steuer- und/oder Regeleinrichtung (5) eine Steuerleitung (51) enthält, mit welcher einzelne Batteriezellen (11) beeinflussbar sind.

9. Verfahren zur Steuerung oder Regelung der Ladung und/oder Entladung einer Batterie (1) mit zumindest einer Batteriezelle (11), bei welchem Messwerte mit zumindest einem faseroptischen Sensor (2) erfasst werden, welcher zumindest einen Wellenleiter (20) mit einem Kern und einem den Kern umgebenden Mantel aufweist, wobei im Kern zumindest ein erstes Faser-Bragg-Gitter (21) eingebracht ist, welches mechanisch mit dem Batteriegehäuse (10) und/oder der Batteriezelle (11) gekoppelt ist, um eine Größenänderung des Batteriegehäuses (10) und/oder der Batteriezelle (11) zu erfassen, und im Kern zumindest ein zweites Faser-Bragg-Gitter (22) eingebracht ist, wobei das zweite Faser-Bragg-Gitter (22) mechanisch von dem Batteriegehäuse (10) und der Batteriezelle (11) entkoppelt ist, um eine Temperatur des Batteriegehäuses (10) und/oder der Batteriezelle (11) zu erfassen **dadurch gekennzeichnet, dass**
der Sensor (2) in eine Trägerfolie (4) eingebettet ist und das zweite Faser-Bragg-Gitter (22) in einer Teilfläche der Trägerfolie (4) angeordnet ist, in welcher eine Faserverstärkung (40) eingebracht ist.

10. Verfahren nach Anspruch 9, **dadurch gekennzeichnet, dass** jeder Batteriezelle (11) einer Batterie (1) zumindest ein erstes Faser-Bragg-Gitter (21) und zumindest ein zweites Faser-Bragg-Gitter (22) zugeordnet ist, so dass die Verformung und die Temperatur jeder Batteriezelle (11) erfasst wird.

11. Verfahren nach einem der Ansprüche 9 oder 10, **dadurch gekennzeichnet, dass** einzelne Batteriezellen (11) bei Vorliegen einer Fehlfunktion abgeschaltet werden.

12. Verfahren nach Anspruch 11, **dadurch gekennzeichnet, dass** eine Fehlfunktion bei unzulässiger Temperaturerhöhung und/oder unzulässig großer Ausdehnung erkannt wird.

13. Verfahren nach einem der Ansprüche 9 bis 11, **dadurch gekennzeichnet, dass** eine Fehlfunktion bei Auftreten einer Dehnung von mehr als 50 µm/m angenommen wird.

## Claims

1. Battery (1) having a battery housing (10) and at least one battery cell (11) and at least one fiber-optic sensor (2), which has at least one waveguide (20) including a core and a cladding surrounding the core, wherein at least one first fiber Bragg grating (21) is introduced in the core, said first grating being mechanically coupled to the battery housing (10) and/or the battery cell (11), and at least one second fiber Bragg grating (22) is introduced in the core, said second fiber Bragg grating (22) being mechanically decoupled from the battery housing (10) and/or the battery cell (11), and
**characterized in that** the sensor (2) is embedded in a carrier film (4) and the second fiber Bragg grating (22) is arranged in a subarea of the carrier film (4) where a fiber reinforcement (40) is introduced.

2. Battery according to claim 1, **characterized in that** the waveguide (20) has at least one curve (25) so that the longitudinal portion with the second fiber Bragg grating (22) is approximately orthogonal to the longitudinal portion with the first fiber Bragg grating (21).

3. Battery according to any of claims 1 or 2, **characterized in that** the carrier film is connected to a battery cell (11) or a battery housing (10) by bonding, welding or shrinking.

4. Battery according to any of claims 1 to 3, **characterized in that** each battery cell (11) of a battery (1) is associated with at least one first fiber Bragg grating (21) and at least one second fiber Bragg grating (22).

5. Battery according to any of claims 1 to 4, further containing an open loop and/or closed loop control device (5), which is coupled to at least one sensor (2).

6. Battery according to claim 5, **characterized in that** the open loop and/or closed loop control device (5) contains a light source and a micro-optical spectrometer.

7. Battery according to claim 5 or 6, **characterized in that** the open loop and/or closed loop control device (5) contains or consists of a microprocessor or a microcontroller.

8. Battery according to any of claims 5 to 7, **characterized in that** the open loop and/or closed loop control device (5) contains a control line (51), by means of which individual battery cells (11) can be influenced.

9. Method for the open loop control or closed loop control of the charging and/or discharging of a battery (1) having at least one battery cell (11), in which measured values are detected with at least one fiber-optic sensor (2), which has at least one waveguide (20) including a core and a cladding surrounding the core, wherein at least one first fiber Bragg grating (21) is introduced in the core, the first grating being mechanically coupled to the battery housing (10) and/or the battery cell (11) in order to detect a change in the size of the battery housing (10) and/or the battery cell (11), and at least one second fiber Bragg grating (22) is introduced in the core, the second fiber Bragg grating (22) being mechanically decoupled from the battery housing (10) and the battery cell (11) in order to detect a temperature of the battery housing (10) and/or the battery cell (11)
**characterized in that**
the sensor (2) is embedded in a carrier film (4) and the second fiber Bragg grating (22) is arranged in a subarea of the carrier film (4) where a fiber reinforcement (40) is introduced.

10. Method according to claim 9, **characterized in that** each battery cell (11) of a battery (1) is associated with at least one first fiber Bragg grating (21) and at least one second fiber Bragg grating (22) so as to detect the deformation and the temperature of each battery cell (11).

11. Method according to any of claims 9 or 10, **characterized in that** individual battery cells (11) are switched off when there is a malfunction.

12. Method according to claim 11, **characterized in that** a malfunction is detected when there is an impermissible temperature increase and/or an impermissibly large expansion.

13. Method according to any of claims 9 to 11, **characterized in that** a malfunction is assumed when there is an elongation of more than 50 µm/m.

## Revendications

1. Batterie (1) comportant un boîtier (10) et au moins une cellule (11) et au moins un capteur à fibre optique (2) qui comprend au moins un guide d'ondes (20) présentant un noyau et une gaine entourant le noyau,
dans laquelle
au moins un premier réseau de Bragg à fibres (21) est intégré dans le noyau, qui est couplé mécaniquement au boîtier (10) et/ou à la cellule (11) de la batterie, et
au moins un second réseau de Bragg à fibres (22) est intégré dans le noyau,
le second réseau de Bragg à fibres (22) est découplé mécaniquement du boîtier (10) et de la cellule (11) de la batterie,
**caractérisée en ce que**
le capteur (2) est noyé dans une feuille de support (4) et le second réseau de Bragg à fibres (22) est agencé dans une surface partielle de la feuille de support (4) dans laquelle est intégré un renfort de fibres (40).

2. Batterie selon la revendication 1,
**caractérisée en ce que**
le guide d'ondes (20) comprend au moins un coudage (25), de sorte que la portion longitudinale présentant le second réseau de Bragg à fibres (22) s'étend approximativement orthogonalement à la portion longitudinale présentant le premier réseau de Bragg à fibres (21).

3. Batterie selon l'une des revendications 1 ou 2,
**caractérisée en ce que**
la feuille de support est reliée à une cellule (11) ou au boîtier (10) de la batterie par collage, par soudage ou par rétraction.

4. Batterie selon l'une des revendications 1 à 3,
**caractérisée en ce que**
au moins un premier réseau de Bragg à fibres (21) et au moins un second réseau de Bragg à fibres (22) sont associés à chaque cellule (11) d'une batterie (1).

5. Batterie selon l'une des revendications 1 à 4,
comportant en outre un moyen de commande et/ou de régulation (5) qui est couplé à au moins un capteur (2).

6. Batterie selon la revendication 5,
**caractérisée en ce que**
le moyen de commande et/ou de régulation (5) comprend une source de lumière et un spectromètre micro-optique.

7. Batterie selon la revendication 5 ou 6,
**caractérisée en ce que**
le moyen de commande et/ou de régulation (5) comprend un microprocesseur ou un microcontrôleur, ou en est constitué.

8. Batterie selon l'une des revendications 5 à 7,
**caractérisée en ce que**
le moyen de commande et/ou de régulation (5) comprend une ligne de commande (51) permettant d'influer sur des cellules individuelles (11) de la batterie.

9. Procédé pour commander ou réguler la charge et/ou la décharge d'une batterie (1) pourvue d'au moins une cellule (11), dans lequel des valeurs de mesure sont acquises par au moins un capteur à fibre optique (2) qui comprend au moins un guide d'ondes (20) présentant un noyau et une gaine entourant le noyau,
dans lequel
au moins un premier réseau de Bragg à fibres (21) est intégré dans le noyau, qui est couplé mécaniquement au boîtier (10) et/ou à la cellule (11) de la batterie, pour détecter un changement de la taille du boîtier (10) et/ou de la cellule (11), et
au moins un second réseau de Bragg à fibres (22) est intégré dans le noyau,
le second réseau de Bragg à fibres (22) est découplé mécaniquement du boîtier (10) et de la cellule (11) de la batterie, pour détecter une température du boîtier (10) et/ou de la cellule (11),
**caractérisé en ce que**
le capteur (2) est noyé dans une feuille de support (4) et le second réseau de Bragg à fibres (22) est agencé dans une surface partielle de la feuille de support (4) dans laquelle est intégré un renfort de fibres (40).

10. Procédé selon la revendication 9,
**caractérisée en ce que**
au moins un premier réseau de Bragg à fibres (21) et au moins un second réseau de Bragg à fibres (22) sont associés à chaque cellule (11) d'une batterie (1), de manière à détecter la déformation et la température de chaque cellule (11).

11. Procédé selon l'une des revendications 9 ou 10,
**caractérisé en ce que**
des cellules individuelles (11) de la batterie sont déconnectées en présence d'une erreur de fonctionnement.

12. Procédé selon la revendication 11,
**caractérisé en ce que**
un dysfonctionnement est identifié dans le cas d'une augmentation inadmissible de la température et/ou d'une extension élevée inadmissible.

13. Procédé selon l'une des revendications 9 à 11,
**caractérisé en ce que**
un dysfonctionnement est supposé lors de l'apparition d'une dilatation de plus de 50 µm/m.
